# EUROPEAN PATENT APPLICATION

(11) **EP 4 307 334 A1**
(43) Date of publication of application: **17.01.2024**
(21) Application number: 22184926.8
(22) Date of filing: 14.07.2022
(51) Int. Cl.: H01J 37/04, H01J 37/248

(54) **ELECTRON-OPTICAL ASSEMBLY**

(71) Applicant: ASML Netherlands B.V., 5500 AH Veldhoven (NL)
(72) Inventor: KONING, Johan, Joost, 5500 AH Veldhoven (NL); DOESBURG, Olivier, Jacob, 5500 AH Veldhoven (NL); ZIJL, Gomaar, 5500 AH Veldhoven (NL)
(74) Representative: ASML Netherlands B.V.

(57) **Abstract**

A charged particle-optical assembly configured to direct a plurality of beams of charged particles in a beam grid towards a sample location, the charged particle-optical assembly comprising: a planar charged particle-optical element configured to operate at a voltage on charged particle beams of a beam grid, the charged particle-optical element comprising a plurality of apertures for the paths of different beams of the beam grid; a conductive body electrically connected to the charged particle-optical element, wherein a recess is defined within the conductive body and is configured to provide a field free volume for insertion of an electrical coupling to electrically connect the charged particle-optical element via the electrical coupling with an electrical power source; and an electrical insulator covering at least part of a surface of the conductive body, the surface facing away from the charged particle-optical element.

## Description

### FIELD

The embodiments provided herein generally relate to a charged particle-optical assembly, a charged particle-optical device, a charged particle-optical apparatus and a method for providing an electrical connection and a method of electrically insulating a conductive body of a charged particle-optical assembly.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection apparatus has a single beam and may be referred to as a Single Beam SEM. There have been attempts to introduce a multi-electron beam inspection in an apparatus (or a 'multi-beam tool') which may be referred to as Multi Beam SEM (MBSEM).

Another application for an electron-optical device (or device or column) is lithography. The charged particle beam reacts with a resist layer on the surface of a substrate. A desired pattern in the resist can be created by controlling the locations on the resist layer that the charged particle beam is directed towards.

An electron-optical device may be an apparatus for generating, illuminating, projecting and/or detecting one or more beams of charged particles. The path of the beam of charged particles is controlled by electromagnetic fields (i.e. electrostatic fields and magnetic fields). Stray electromagnetic fields can undesirably divert the beam.

In some electron-optical devices an electrostatic field is typically generated between two electrodes. There exists a need to apply high voltages to the electrodes. There is a possibility of electron creep undesirably occurring and consequential undesired discharge, for example between high voltage connectors and/or between a high voltage connector and an electron-optical assembly of the electron-optical device.

### SUMMARY

The present invention provides a suitable architecture to enable the desired high voltage connection with a reduced risk of electron creep. According to a first aspect of the invention, there is provided a charged particle-optical assembly configured to direct a beam of charged particles along a beam path towards a sample location, the charged particle-optical assembly comprising: a planar charged particle-optical element configured to operate on a charged particle beam along a beam path towards a sample location, the charged particle-optical element comprising an aperture for the beam path; and a conductive body electrically connected to the charged particle-optical element, wherein a recess is defined within the conductive body and is configured to provide a field free volume for insertion of a high voltage cable for electrically connecting the charged particle-optical element via an electrical coupling with an electrical power source; wherein the conductive body comprises an electrical insulator spaced away from the planar charged particle-optical element and providing a at least part of a surface of the conductive body.

According to a second aspect of the invention, there is provided a charged particle-optical assembly configured to direct a plurality of beams of charged particles along a beam path towards a sample location, the charged particle-optical assembly comprising: a planar charged particle-optical element configured to operate on a charged particle beam along a beam path towards a sample location, the charged particle-optical element comprising an aperture for the beam path; and a conductive body electrically connected to the charged particle-optical element, wherein a recess is defined within the conductive body and is configured to provide a field free volume for insertion of a high voltage cable for electrically connecting the charged particle-optical element via an electrical coupling with an electrical power source; wherein an electrical insulator covers at least part of a surface of the conductive body, the surface facing away from the charged particle-optical element.

According to a third aspect of the invention, there is provided a method of electrically insulating a conductive body of a charged particle-optical assembly configured to direct a beam of charged particles towards a sample location, the method comprising: covering at least part of a surface of the conductive body with one or more electrical insulators, the surface facing away from a planar charged particle-optical element to which the conductive body is electrically connected, the charged particle-optical element configured to operate on a charged particle beam along a beam path and comprising an aperture for the beam path, wherein a recess is defined within the conductive body and is configured to provide a field free volume for insertion of a high voltage cable for electrically connecting the charged particle-optical element via an electrical coupling with an electrical power source.

According to a fourth aspect of the invention, there is provided a method of electrically insulating a conductive body of a charged particle-optical assembly configured to direct a beam of charged particles along a beam path towards a sample location, the charged particle-optical assembly comprising a planar charged particle-optical element for operating on the charged particle beam, the method comprising: having a conductive body having a conductive recessed surface of a recess of the conductive body, the conductive body comprising an electrical insulator spaced away from the planar charged particle-optical element, the planar charged particle-optical element electrically connected to the conductive body, wherein the recess is configured within the conductive body to provide a field free volume for insertion of a high voltage cable for electrical connection of the charged particle-optical element via an electrical coupling between the conductive body and the high voltage cable to an electrical power source.

According to a fifth aspect of the invention, there is provided a charged particle-optical assembly configured to direct a plurality of beams of charged particles along a beam path towards a sample location, the charged particle-optical assembly comprising: a planar charged particle-optical element configured to operate at a voltage on a charged particle beam along a beam path towards a sample, the charged particle-optical element comprising an aperture for the beam path; and a conductive body electrically connected to the charged particle-optical element, wherein a recess is defined within the conductive body and is configured to provide a field free volume for insertion of a high voltage cable for electrical connection of the charged particle-optical element via an electrical coupling with an electrical power source; wherein the conductive body comprises an electrical insulator that comprises at least an end face of the conductive body and an extending surface extending from the end face into the recess.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam inspection apparatus.
Figure 2 is a schematic diagram illustrating an exemplary multi-beam electron-optical device that is part of the exemplary electron beam inspection apparatus of Figure 1.
Figure 3 is a schematic diagram of an exemplary electron-optical device comprising a collimator element array and a scan-deflector array that is part of the exemplary electron beam inspection apparatus of Figure 1.
Figure 4 is a schematic diagram of an exemplary electron-optical device array comprising the electron-optical devices of Figure 3.
Figure 5 is a schematic diagram of an alternative exemplary electron-optical device that is part of the exemplary electron beam inspection apparatus of Figure 1.
Figure 6 is a schematic diagram of an exemplary electron-optical assembly that is part of the electron-optical devices of Figures 3, 4 and 5.
Figure 7 is a schematic diagram of an electron-optical element electrically connected to a cable.
Figure 8 is a schematic diagram of an electron-optical element electrically connected to a cable.
Figure 9 is a plan view of an electron-optical assembly.
Figure 10 is a plan view of an electron-optical assembly.
Figure 11 is a plan view of an electron-optical assembly.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### BRIEF DESCRIPTION OF FIGURES

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of electron-optical apparatus embodying these scanning electron microscope features may have a single beam. For higher throughput such as for inspection, some designs of apparatus use multiple focused beams, i.e. a multibeam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the signal particles (e.g. secondary electrons) from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

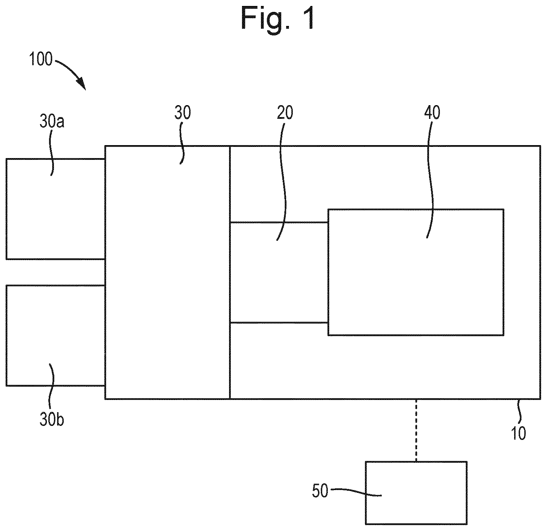

Reference is now made to Figure 1, which is a schematic diagram illustrating an exemplary electron beam assessment apparatus, or inspection apparatus, 100. The inspection apparatus 100 of Fig. 1 includes a vacuum chamber 10, a load lock chamber 20, an electron-optical apparatus, an equipment front end module (EFEM) 30 and a controller 50. The electron-optical device 40 may be within the vacuum chamber 10. The electron-optical apparatus may comprise an electron-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical device 40 by which it may be inspected. An electron-optical device 40 may comprise either a single beam or a multi-beam electron-optical apparatus.

The controller 50 is electronically connected to the electron-optical device 40. The controller 50 may be a processor (such as a computer) configured to control the charged particle beam inspection apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection apparatus, it should be noted that aspects of the disclosure in their broadest sense are not limited to a chamber housing an electron-optical device. Rather, it is appreciated that the foregoing principles may also be applied to other apparatuses and other arrangements of apparatus that operate under the second pressure.

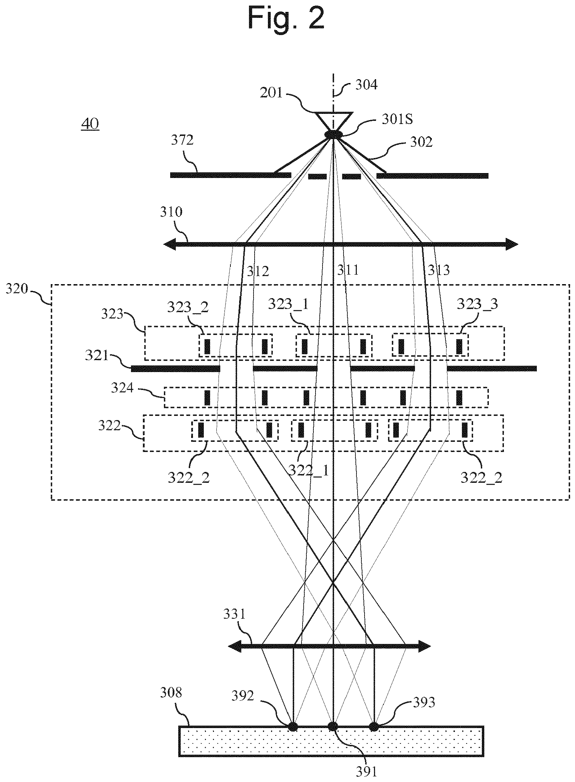

Reference is now made to Figure 2, which is a schematic diagram of an exemplary multibeam electron-optical device 40 of an assessment apparatus, e.g. the assessment apparatus 100 of Figure 1. In an alternative embodiment the inspection apparatus 100 is a single-beam inspection apparatus. The electron-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. (A single beam assessment apparatus may have the same features as a multibeam assessment apparatus except electron-optical components with an array apertures 372, 320 may have a single aperture. The source converter 320 may be replaced with a number of electron-optical components along the beam path). The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical device 40. The source converter 320 (also known as a source conversion unit), described in more detail below, and the objective lens 331 may be the components of a projection apparatus comprised by the electron-optical device 40.

The electron source 201, the beam former array 372, the condenser lens 310, the source converter 320, and the objective lens 331 are aligned with a primary electron-optical axis 304 of the electron-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical device 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may be electron-optical assembly 700 as herein described. The source converter 320 may comprise a pre-bending deflector array 323,a beam-limiting aperture array 321, an aberration compensator array 324, and an image-forming element array 322. The pre-bending deflector array 323 may comprise pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of on beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical device 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be upbeam of the objective lens 331. The beam separator may be positioned between adjacent sections of shielding in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such a Wien filter, a secondary device and/or a secondary projection apparatus may be provided in a single beam assessment apparatus. Additionally and/or alternatively a detection device may be present down beam of the objective lens, for example facing the sample during operation. In an alternative arrangement a detector device is position along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electro-static plates may be arranged in series of two or more adjoining plates along the path of the charged particle beam.

In an embodiment the inspection apparatus 100 comprises a single source.

Any element or collection of elements may be replaceable or field replaceable within the electron-optical device. The one or more electron-optical components in the electron-optical device, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

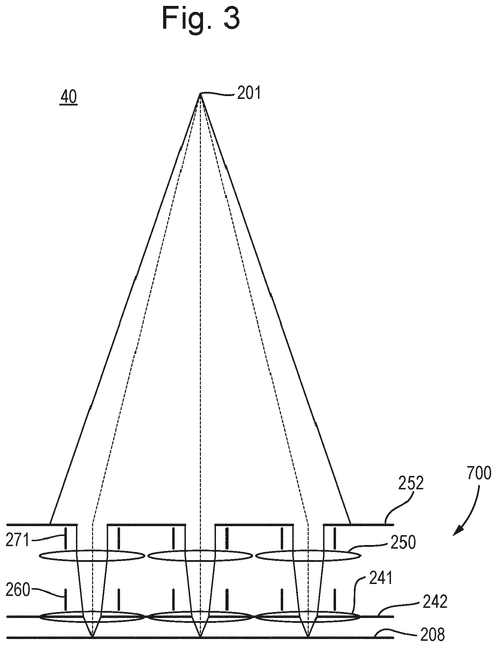

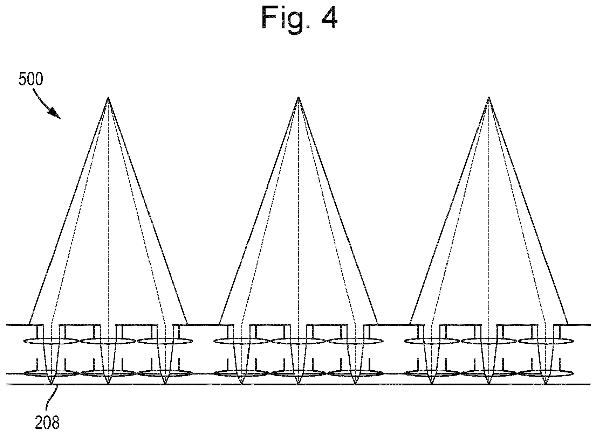

In an embodiment the electron-optical device 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical device 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array which may correspond to the array of the beamlets of the multi-beam arrangement. The detectors in the detector array may generate detection signals that may be associated with the pixels of a generated image. The condenser lenses, objective lenses and/or detector may be formed as MEMS or CMOS devices.

Figure 3 is a schematic diagram of another design of an exemplary electron-optical device 40. The electron-optical device 40 may comprise a source 201 and one or more electron-optical assemblies. Alternatively, the electron-optical apparatus that comprises the electron-optical device 40 may comprise the source 201. The electron-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. Although the control lens array 241 may be indistinct from and part of the objective lens array 250, in this description the control lens array 250 is considered to be distinct and separate from the objective lens array 241.

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one more extra degrees of freedom to the objective lens.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of a two electrode lens over an Einzel lens is that the energy of an incoming beam is not necessarily the same as an outgoing beam. Beneficially the potential differences on such a two electrode lens array enables it to function as either an accelerating or a decelerating lens array.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. The apertures of the beam shaping limiter 242 may have a smaller diameter than the apertures of at least one of the objective lens array 242, the control lens array 250, the detector array 240 and the upper beam limiter array 252. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical device 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. Note, the most down-beam electrode of the control lens array 250 may be the most up-beam electrode of the objective lens array 241. That is the control lens array 250 and the objective lens array 241 may share an electrode. The shared electrode provides different lensing effects for each lens, each lensing effect with respect one its two opposing surfaces (i.e. up beam surface and down beam surface). The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles (e.g. signal particles) detected by a scanning electron microscope, including secondary and/or backscattered electrons from the sample 208. The detector may be an array providing the surface of the electron-optical device facing the sample 208, e.g. the bottom surface of the electron-optical device. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical device array 500 is provided. The array 500 may comprise a plurality of any of the electron-optical devices described herein. Each of the electron-optical devices focuses respective multi-beams simultaneously onto different regions of the same sample. Each electron-optical device may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical devices in the array 500 may be arranged adjacent to each other so as to project the respective multi-beams onto adjacent regions of the sample 208.

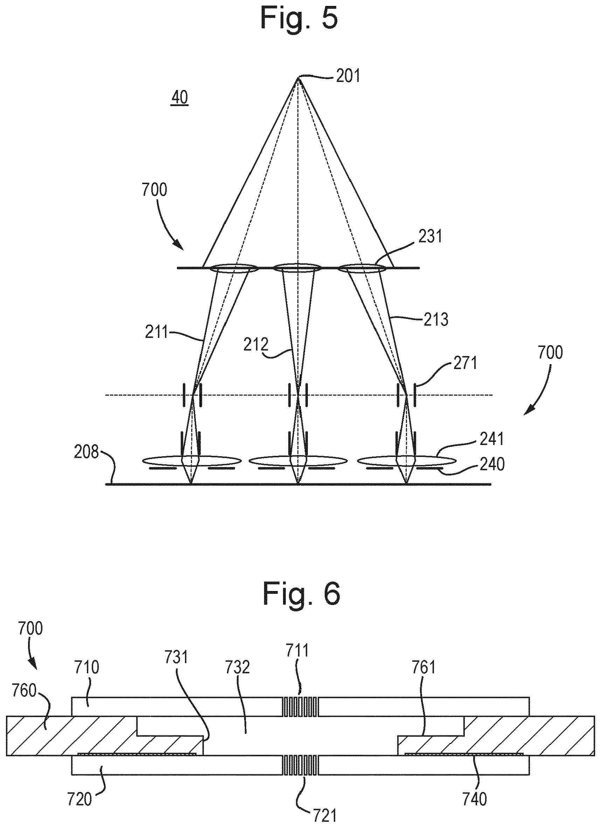

Any number of electron-optical devices may be used in the array 500. Preferably, the number of electron-optical devices is in the range of from two (2), desirably nine (9) to one hundred (100) even two hundred (200). In an embodiment, the electron-optical devices are arranged in a rectangular array or in a hexagonal array. In other embodiments, the electron-optical devices are provided in an irregular array or in a regular array having a geometry other than rectangular or hexagonal. Each electron-optical device in the array 500 may be configured in any of the ways described herein when referring to a single electron-optical device, for example as described above, especially with respect to the embodiment shown and described in reference to Fig 6. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of electron-optical devices of the type described above with reference to Figure 3. Each of the electron-optical devices in this example thus comprise both a scan-deflector array 260 and a collimator element array 271. As mentioned above, the scan-deflector array 260 and collimator element array 271 are particularly well suited to incorporation into an electron-optical device array 500 because of their spatial compactness, which facilitates positioning of the electron-optical devices close to each other. This arrangement of electron-optical device may be preferred over other arrangements that use a magnetic lens as collimator. Magnetic lenses may be challenging to incorporate into an electron-optical device intended for use in a multi-device arrangement (e.g. multi-column arrangement) for example because of magnetic interference between columns.

An alternative design of multi-beam electron-optical device may have the same features as described with respect to Figure 3 expect as described below and illustrated in Figure 5. The alternative design of multi-beam electron-optical device may comprise a condenser lens array 231 upbeam of the object lens array arrangement 241, as disclosed in EP application 20158804.3 filed on 21 February 2020 which is hereby incorporated by reference so far as the description of the multibeam device with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use.

In an embodiment of the arrangement shown in and described with reference to Figure 5, the detector may be located in similar locations in the electron-optical device 241 as described with reference to and as shown in the electron-optical device of Figure 3. The detector 250 may be integrated into the objective lens array 241 and the control lens array 240 (when present as it is not depicted in Figure 5). The detector may have more than one detector at different positions along the paths of the sub-beams of the multi-beam, for example each array associated with a different electron-optical element, such as an electrode of the objective lens array and/or the control lens array. The objective lens array 241 and associated electron-optical elements such as the control lens array 240 may be comprised in assembly which may be a mono-lithic assembly which may be referred to as an electron-optical assembly 700. In an embodiment a detector 240 is associated with, or even integrated into, a plate 710, 720 of the electron-optical assembly 700. For example, the detector 240 may be on the bottom surface of an electron-optical assembly 700 comprising objective lenses 241. The detector 240 may be provided with an electric connection 60 as described elsewhere in this document. In a variation, the detector has a detector array positioned up beam of the objective lens array (optionally and the control lens array 240) for example up beam of the electron-optical assembly 700. Between the electron-optical assembly 700 and the detector array may be a Wien filter array that directs the charged particles beams in a down beam direction towards the sample and directs signal particles from the sample to the detector array.

An electron-optical device array may have multiple multi-beam devices of this design as described with reference to the multi-beam device of Figure 3 as shown in Figure 4. The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at an intermediate focus.

A further alternative design of multi-beam apparatus comprises multiple single beam devices. The single beams generated for the purposes of the invention herein described may be similar or equivalent to a multi-beam generated by a single device. Each device may have an associated detector. Such a multi-device apparatus may be arranged in an array of devices of three, four, nine, nineteen, fifty, one hundred or even two hundred devices each generating a single beam or beamlet (if of a single beam device) or a plurality of beams (if of multibeam devices). In this further alternative design the array of devices may have a common vacuum system, each device have a separate vacuum system or groups of devices are assigned different vacuum systems. Each device may have an associated detector.

The electron-optical device 40 may be a component of an assessment (e.g. inspection or metro-inspection) apparatus or part of an e-beam lithography apparatus. The multi-beam charged particle apparatus may be used in a number of different applications that include electron microscopy in general, not just scanning electron microscopy, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, for example of the arrangement shown and described with reference to Figure 2, unless explicitly mentioned. The electron-optical axis 304 may be the same as, or different from, a mechanical axis of the electron-optical device 40. In the context of the arrangement shown and described with respect to Figures 2 to 5, the electron-optical axis may correspond to the path of the central beam of the multibeam, for example beam 212. The beams of the multibeam are substantially parallel to each other (for example the electron-optical axis 304) between collimation (e.g. the location of the collimator array 271 which corresponds to a plane of intermediate foci (for example as shown in Figure 5) or an upper beam limiter 252) and the surface of the sample 208.

The electron-optical device 40 may comprise an electron-optical assembly 700 as shown in Figure 6 for manipulating electron beamlets. For example, the electron-optical assembly 700 may comprise one more of (in a non-limited list): the objective lens array 241, and/or the condenser lens array 231 may comprise the electron-optical assembly 700 and/or the collimator element array 271 and/or an individual beam corrector and/or a deflector and/or a Wien filter array. In particular, the objective lens 331 and/or the condenser lens 310 and/or the control lens 250 may comprise the electron-optical assembly 700.

The electron-optical assembly is configured to provide a potential difference between two or more plates (or substrates). An electrostatic field is generated between the plates, which act as electrodes. The electrostatic field results in an attraction force between the two plates. The attraction force may be increased with increasing potential difference.

In the electron-optical assembly, at least one of the plates has a thickness which is stepped such that the array plate is thinner in the region corresponding to the array of apertures than another region of the array plate. It is advantageous to have a stepped thickness, for example with two portions of the plate having different thicknesses, because at high potential differences the plate is subjected to higher electrostatic forces which can result in bending if the plate were a consistent thickness and, for example, too thin. Bending of the plate can adversely affect beam-to-beam uniformity. Thus, a thick plate is advantageous to mitigate bending. However, if the plate is too thick in the region of the array of apertures, it can result in undesirable electron beamlet deformation. Thus, a thin plate around the array of apertures is advantageous to mitigate electron beamlet deformation. That is in a region of the plate thinner than the rest of the plate the array of apertures may be defined. The stepped thickness of the plate thus reduces the likelihood of bending, without increasing the likelihood of beamlet deformation. In an embodiment the plates have uniform thickness including in the region corresponding to the array of apertures.

The exemplary electron-optical assembly shown in Figure 6 comprises an array plate 710, an adjoining plate 720 and an isolator (or spacer) 730. (Note the term 'array plate' is a term used to different the plate from other plates referred to in the description). In the array plate, an array of apertures 711 is defined for the path of electron beamlets. The number of apertures in the array of apertures may correspond to the number of sub-beams in the multi-beam arrangement. In one arrangement there are fewer apertures than sub-beams in the multi-beam so that groups of sub-beam paths pass through an aperture. For example an aperture may extend across the multi-beam path; the aperture may be a strip or slit. In an arrangement, the apertures may be arranged in a grid (or two dimensional array) so that groups are of beams are arranged in a two dimensions array of groups of beams. The isolator 730 is disposed between the plates to separate the plates. The electron-optical assembly is configured to provide a potential difference between the array plate 710 and the adjoining plate 720.

In the adjoining plate 720, another array of apertures 721 is defined for the path of the electron beamlets. In an embodiment the adjoining plate 720 may also have a thickness which is stepped such that the adjoining plate is thinner in the region corresponding to the array of apertures than another region of the adjoining plate. (Alternatively the adjoining plate 720 is substantially planar and/or has uniform thickness). Desirably, the array of apertures 721 defined in the adjoining plate 720 has the same pattern as the array of apertures 711 defined in the array plate 710. In an arrangement the pattern of the array of apertures in the two plates may be different. For example, the number of apertures in the adjoining plate 720 may be fewer or greater than the number of apertures in the array plate 710. In an arrangement there is a single aperture in the adjoining plate for all the paths of the sub-beams of the multi-beam. Preferably the apertures in the array plate 710 and the adjoining plate 720, are substantially mutually well aligned. This alignment between the apertures is in order to limit lens aberrations

The array plate and the adjoining plate may each have a thickness of up to 1.5 mm at the thickest point of the plate, preferably 1 mm, more preferably 500 µm. In an arrangement, the downbeam plate (i.e., the plate closer to the sample) may have a thickness of between 200 µm and 300 µm at its thickest point. The downbeam plate preferably a thickness of between 200 µm and 150 µm at its thickest point. The upbeam plate (i.e., the plate farther from the sample) may have a thickness of up to 500 µm at its thickest point.

A coating may be provided on a surface of the array plate and/or the adjoining plate. Preferably both the coating is provided on the array plate and the adjoining plate. The coating reduces surface charging which otherwise can result in unwanted beam distortion.

The coating is configured to survive a possible electric breakdown event between the array plate and the adjoining plate. Preferably, a low ohmic coating is provided, and more preferably a coating of 0.5 Ohms/square or lower is provided. The coating is preferably provided on the surface of the downbeam plate. The coating is more preferably provided between at least one of the plates and the isolator. The low ohmic coating reduces undesirable surface charging of the plate.

The array plate and/or the adjoining plate may comprise a low bulk resistance material, preferably a material of 1 Ohm.m or lower, optionally 0.1 Ohm.m or lower, optionally 0.01 Ohm.m or lower, optionally 0.001 Ohm.m or lower, and optionally 0.0001 Ohm.m or lower. More preferably, the array plate and/or the adjoining plate comprises doped silicon. Plates having a low bulk resistance have the advantage that they are less likely to fail because the discharge current is supplied/drained via the bulk and not, for example, via the thin coating layer.

The array plate comprises a first wafer. The first wafer may be etched to generate the regions having different thicknesses. The first wafer may be etched in the region corresponding to the array of apertures, such that the array plate is thinner in the region corresponding to the array of apertures. For example, a first side of a wafer may be etched or both sides of the wafer may be etched to create the stepped thickness of the plate. The etching may be by deep reactive ion etching. Alternatively or additionally, the stepped thickness of the plate may be produced by laser-drilling or machining.

Alternatively, the array plate may comprise a first wafer and a second wafer. The aperture array may be defined in the first wafer. The first wafer may be disposed in contact with the isolator. A second wafer disposed on a surface of the first wafer in a region not corresponding to the aperture array. The first wafer and the second wafer may be joined by wafer bonding. The thickness of the array plate in the region corresponding to the array of apertures may be the thickness of the first wafer. The thickness of the array plate in another region, other than the region of the array of apertures, for example radially outward of the aperture array, may be the combined thickness of the first wafer and the second wafer. Thus, the array plate has a stepped thickness between the first wafer and the second wafer.

One of the array plate and the adjoining plate is upbeam of the other. One of the array plate and the adjoining plate is negatively charged with respect to the other plate. Preferably the upbeam plate has a higher potential than the downbeam plate with respect to for example to a ground potential, the source or of the sample. The electron-optical assembly may be configured to provide a potential difference of 5 kV or greater between the array plate and the adjoining plate. Preferably, the potential difference is 10 kV or greater. More preferably, the potential different is 20 kV or greater, or less than 30kV or even greater than 30kV.

The isolator 760 is preferably disposed between the array plate and the adjoining plate such that the opposing surfaces of the plates are co-planar with each other. The isolator 760 has an inner surface 731 facing the path of the beamlets. The isolator may be planar with major surfaces coplanar with the plates 710, 720. The isolator 760 defines an opening 732, for the path of the electron beamlets.

A conductive coating may be applied to the isolator, for example coating 740. Preferably, a low ohmic coating is provided, and more preferably a coating of 0.5 Ohms/square or lower is provided.

The coating is preferably on the surface of the space facing the negatively charged plate, which is negatively charged with respect to the other plate. The downbeam plate is preferably negatively charged with respect to the upbeam plate. The coating shall be put at the same electric potential as the negatively charged plate. The coating is preferably on the surface of the isolator facing the negatively charged plate. The coating is more preferably electrically connected to the negatively charged plate. The coating ensures that there is an electrostatic field over any possible voids in between the isolator and the negatively charged plate.

In absence of such a coating on the isolator, electric field enhancement may occur in those voids. This electric field enhancement can result in electric breakdown in these voids and thereby in electric potential instability of the lower electrode. This potential instability results in varying lens strength over time, thereby defocusing the electron beams.

An inner surface 731of the spacer 760 (or rim) is shaped such that a creep path between the plates over the inner surface is longer than a minimum distance between the plates. The inner surface may feature a step 761. The step may be step in the thickness of the isolator. The step may have a surface coplanar with the major surfaces of the isolator. Thus the creep length is over the inner surface 731 of the spacer between the two different plates for example over the step 761. Desirably, the inner surface of the isolator is shaped to provide a creep length of 10 kV/mm or less, preferably 3 kV/mm or less.

The electron-optical assembly 700 may comprise or be a lens assembly for manipulating electron beamlets. The lens assembly may, for example, be, or may be part of, an objective lens assembly or a condenser lens assembly. The lens assembly, such as an objective lens assembly, may further comprise an additional lens array comprising at least two plates such as a control lens array 250.

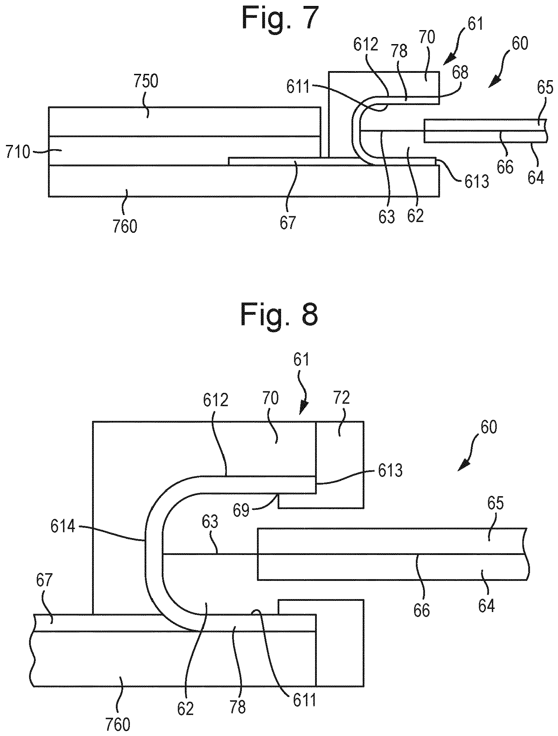

Figure 7 is a schematic diagram of an electrical connector 60 of an exemplary electron-optical assembly 700. The electron-optical assembly 700 is configured to manipulate the electron beams. As shown in Figure 7, in an embodiment the electron-optical assembly 700 comprises a first electron-optical element comprising a plate 710. (Note if the electron-optical assembly 700 comprises just one first electron element, the first electron-optical element may be referred to as an or the electron-optical element).

In an embodiment the electron-optical assembly 700 comprises a plurality of electron-optical elements each comprising a plate. For example, the electron-optical assembly 700 shown in Figure 6 comprises a first electron-optical element comprising a plate 710 and a second electron-optical element comprising another plate 720. In an embodiment the electron-optical assembly 700 comprises more than two electron-optical elements each comprising a plate. The electrical connector 60 described in this document may be applied for connecting any or each of the plates 710, 720 of the electron-optical assembly 700 to an electrical power source (or power supply).

In an embodiment the plate 710 has one or more apertures 711 around a beam path of the electron beams. For example, as shown in Figure 6 in an embodiment the plate 710 comprises an array of apertures 711. In an alternative embodiment the plate 710 comprises only one aperture. Each aperture 711 may be for the beam path of a single electron beam. Alternatively, one or more apertures 711 may be around the beam path of a plurality of electron beams.

Figure 7 schematically shows an electrical connector 60. The electrical connector 60 is configured to electrically connect the plate 710 of the first electron-optical element to an electrical power source. In an embodiment the electron-optical device 40 comprises the electrical connector 60. In an embodiment the electron-optical assembly 700 comprises the electrical connector 60.

In an embodiment the electrical power source is a high voltage power source. In an embodiment the electrical power source is configured to apply a voltage of at least 100 V, optionally at least 200 V, optionally at least 500 V, optionally at least 1 kV, optionally at least 2 kV, optionally at least 5 kV, optionally at least 10 kV, optionally at least 20 kV, optionally at least 30 kV, and optionally as much as or even more than 35kV to part of the electron-optical assembly 700 relative to a reference potential of the electron-optical device 40. In an embodiment the electrical power source is configured to apply a positive voltage relative to the reference potential. In an alternative embodiment the electrical power source is configured to apply a negative voltage relative to the reference potential. The reference potential may be ground. In an embodiment, one or more of the plates 710, 720 of the electron-optical assembly 700 is configured to be connected to high voltage during use of the electron-optical device 40.

Figure 7 shows an electrical connector 60 for electrically connecting the plate 710 (i.e. a planar electron-optical element) to an electrical power source (e.g. a voltage supply). The planar electron-optical element is configured to operate on an electron beam along a beam path towards a sample location. The electron-optical element may be configured to operate on a single electron beam or a plurality of electron beams (e.g. a multi-beam), which may be formed in a beam grid. In an embodiment the electron-optical element comprises an aperture 711 (or array of apertures) for the beam path.

In an embodiment the electrical connector 60 is for electrically connecting the plate 710 to an electrical power source. The plate 710 may be part of an electron-optical assembly 700 which may comprise for example an objective lens assembly or a condenser assembly. More generally, the electrical connector 60 may be configured to electrically connect any electron-optical element of the electron-optical device 40 to an electrical power source.

As shown in Figure 7, in an embodiment the electron-optical assembly comprises a conductive body 61. The conductive body 61 is electrically connected to the electron-optical element (i.e. plate 710). In an embodiment the conductive body 61 is comprised in the electrical connector 60. The conductive body 61 is for electrically connecting the plate 710 to an electrical power source. The conductive body 61 comprises an electrically conductive material. The conductive body 61 may comprise a metal.

As shown in Figure 7, in an embodiment a recess 611 (e.g. with a recessed surface) is defined within the conductive body 61. In an embodiment the recess 611 is configured to provide a field free volume 62. An opening defined in an end face 613 of the conductive body 61 is the opening to the recess 611 and thus the field free volume 62. In an embodiment the field free volume 62 is for insertion of a high voltage cable 64. In an embodiment the high voltage cable 64 is for electrically connecting the electron-optical element with an electrical power source. In an embodiment the high voltage cable 64 is configured to electrically connect the electron-optical element with the electrical power source via an electrical coupling 63. The field free volume 62 is substantially free of electric fields. In an embodiment the conductive body 61 is configured to shield an electrical component within the field free volume 62 from external electrical fields. In an embodiment the conductive body 61 is configured to reduce the possibility of electrical breakdown between an electrical component within the field free volume 62 and another member of the electron-optical device 40.

The high voltage cable 64 may comprise an insulator 65 and a conductor 66. The conductor 66 is the transmission line. The insulator 65 is configured to insulate the conductor 66 from the environment.

In an embodiment the electrical coupling 63 is flexible. The flexible coupling may be in an electrical path between the plate 710 and the power source. In an embodiment the flexible coupling is configured to electrically connect the plate 710 to the electrical power source, for example thereby enabling the electrical connector 60 to connect the plate 710 to the electrical power source. The plate 710 is electrically connectable to the electrical power source via the flexible coupling 63. Thus the plate 710 is electrically connectable by the electrical power source via to a cable. The electrical path may comprise: the high voltage cable 64, the electrical connector 60 comprising for example the flexile connector 63 and the plate 710.

As shown in Figure 7, in an embodiment the flexible coupling 63 is located within the field free volume 62 (or field free region) for example defined in the conductive body 61. The flexible coupling 63 is intended to provide an electrical connection to the plate 710 for example via an electrical connection to the conductive body 61. The conductive body 61 is configured to shield the flexible coupling 63 from electric fields external to the conductive body 61. An embodiment of the invention is expected to reduce the possibility of electrical breakdown associated with the (electrical) connection of the electron-optical device to an electrical power source, for example between the electrical connector 60 and another component of the electron-optical device 40, for example another component of the electron-optical assembly 700.

The flexibility of the flexible coupling 63 reduces the possibility of the electrical connector 60 undesirably affecting the position and/or formation (e.g. shape) of the plate 710. Such a flexible coupling connected to the electron-optical device may reduce the risk of a force and/or moment being applied to the electron-optical device. Application of such a force or moment may undesirably influence the electron-optical performance of the electron-optical device during operation of the device. Such an influence in performance of the electron-optical device is observable from for example the position of the device, and thus alignment of the device so of the sample, relative to one or more the charged particle beams and between charged particle beams, and other aberrations. Such aberrations may be caused by, for example, changes to stresses within the device and/or the formation of the device, such as through deformation of the shape of an element of the device, causing distortions to the fields generated in the device.

As shown in Figure 7, in an embodiment the conductive body 61 comprises an electrical insulator 70. In an embodiment the electrical insulator 70 is spaced away from the planar electron-optical element. There may be a gap between components of the planar electron-optical element (such as the plate 710) and the electrical insulator 70. In an embodiment the electrical insulator 70 provides at least part of a surface of the conductive body 61. Alternatively, the electrical insulator 70 may be considered to be a different component from the conductive body 61 (such that the conductive body 61 does not comprise the electrical insulator 70). In this case, the electrical insulator 70 is configured to cover at least part of a surface 612 of the conductive body 61. In an embodiment the surface (or part of the surface) 612 of the conductive body 61 covered by the electrical insulator 70 faces away from the electron-optical element.

An embodiment of the invention is expected to reduce the possibility of electron creep. It is possible that electron creep may occur between different parts of the electron-optical device 40. For example, as will be explained in more detail below, in an embodiment the electron-optical assembly comprises a plurality of conducive bodies 61 (of a plurality of respective electrical connectors 60). It is possible for electron creep to occur between the conductive bodies 61. Additionally or alternatively, it is possible for electron creep to occur between the conductive body 61 and an electron-optical component of the electron-optical assembly other than the plate 710 to which the conductive body 61 is electrically connected. Such electron creep is undesirable.

By providing the electrical insulator, the possibility of electrons being released from the conductive body 61 for electron creep is reduced. The possibility of undesirable electron creep is particularly high in case of high electric fields. By providing the electrical insulator 70, it may be possible for the electrical connector 60 to withstand higher electric fields without unduly increasing the risk of electron creep.

In general, the electric fields around the conductive body 61 may be higher where the exterior surface of the conductive body 61 has relatively sharp edges and/or a smaller radius of curvature. By providing the electrical insulator 70, the size of the conductive body 61 may be reduced in volume (which would increase the electric fields around the conductive body 61) without unduly increasing the risk of electron creep. An embodiment of the invention is expected to increase the design freedom for the conductive body 61.

As shown in Figure 7, in an embodiment the electron-optical assembly comprises a plurality of isolators 750, 760. In an embodiment the plate 710 is between isolators 750, 760 e.g. sandwiched by isolators 750, 760. For ease of reference to distinguish the two isolators used in this description the two isolators may be referred to as an up beam isolator 750 and a down beam isolator 760. However the description for the up beam isolator may apply to down beam isolator and vice-versa. Further these terms are relative to the two isolators so that electron-optical module 700 may comprise a further isolator for example located relatively upbeam or down beam of the two isolators 750. 760. In an embodiment the isolators 750, 760 are substantially planar. The isolators 750, 760 and the plate 710 may be stacked relative to each other. The electron-optical assembly may comprise a plurality of plates and a plurality of isolators. The combination of plates and isolators stacked relative to each other may be referred to as a stack.

In an embodiment the down beam isolator 760 is configured to support the electron-optical element. In that embodiment the down beam isolator 760 is configured to electrically isolate the electron-optical element. In an embodiment the down beam isolator 760 is positioned away from the beam path, for example around the beam path. The down beam isolator 760 may be a plate in which is defined an aperture for the beam path, A surface of the plate in the aperture may be referred to as a rim or inner surface 731 The rim may be spaced away (or positioned away) from the beam path. The rim may be spaced away from the beam path and the position of the one more apertures 711, 721 in the plate 710, 720 with which the isolator 760 is in contact.

As shown in Figure 7, in an embodiment the electron-optical assembly comprises a conductor 67. The conductor 67 is configured to electrically connect the plate 710 to the conductive body 61. In an embodiment the conductor 67 comprises a conductive layer recess such as a coating. The conductive layer may be formed on the down beam isolator 760 for example as a coating. The conductor 67 is electrically connected to the conductive body 61. For example, in an embodiment an electrically conductive adhesive (e.g. glue) for example in the form of a ridge is provided to electrically connect the conductor 67 to the conductive body 61. Additionally or alternatively, the conductor 67 may be electrically connected to the conductive body 61 by soldering and/or clamping, for example.

As shown in Figure 7, in an embodiment the conductive body 61 is on the down beam isolator 760. In an embodiment the down beam isolator 760 is configured to mechanically support the conductive body 61. As shown in Figure 7, in an embodiment both the plate 710 and the conductive body 61 electrically connected to the plate 710 are supported by the same down beam isolator 760. However, this is not necessarily the case. In an embodiment the conductive body 61 and the plate to which it is electrically connected may be directly supported by different isolators of the electron-optical assembly. For example, in a modified version of the arrangement shown in Figure 7, the conductive body 61 is electrically connected to another plate mechanically supported by the up beam isolator 750. The conductive body 61 may remain supported by the down beam isolator 760. However, the conductor 67 would be on the up beam isolator 750 (rather than the down beam isolator 760) for extending towards and electrically connecting to the conductive body 61. In an embodiment the conductor 67 electrically connects to a position midway along the conductive body 61 along the direction of the beam path (rather than at the bottom of the conductive body 61 shown in Figure 7).

As shown in Figure 7, for example, in an embodiment the electrical insulator 70 is thicker than the conductive body 61 where the electrical insulator 70 covers the surface 612 of the conductive body 61. By providing the electrical insulator 70, the size of the conductive body 61 may be reduced because the electrical insulator 70 allows greater electric fields around the conductive body 61 without unduly increasing the risk of electrical breakdown. By reducing the size of the conductive body 61, more volume is made available for the electrical insulator 70. In the view shown in Figure 7 or Figure 8, for example, the insulating cover 71 has a greater thickness than the conductive body 61 or the conducting element of the conductive body. In an embodiment the thickness is measured in a direction away from the axial direction of the field free volume 62. The conductive element may be within the electrical insulator 70. The conductive element may comprise a conductive layer for example on the electrical insulator 70. The conductive body may have an end face.

Figure 8 is a schematic diagram of parts of an electron-optical assembly. The electron-optical assembly shown in Figure 8 may be a modified version of the electron-optical assembly shown in Figure 7. Features of the electron-optical assembly shown in Figure 8 that are the same as those described above with reference to Figure 7 are not described in detail below. Instead, the description below focuses on features of the electron-optical assembly of Figure 8 that are not shown in Figure 7.

As shown in Figure 8, in an embodiment the end face 613 of the conductive body 61 comprises the part of the surface of the conductive body 61 that is provided by the electrical insulator 70. In an embodiment the electrical insulator 70 covers an end face 613 of the conductive body 61. In the end face 613 is defined the opening to the field free volume 62. The conductive body may have the sharp edge 68 or end for example of conductive layer 78. The sharp edge 68 may be provided by the opening in the end face 613 of the conductive body 61 and/or an interface between the insulator 71 or isolator 760 and the conductive material of the conductive body 61, e.g. conductive layer 78. The sharp edges defined by the opening and the interfaces may in effect be substantially the same for a conductive body formed from a thin conductive layer such as a coating. Reference in the following text referring to one sharp edge may also apply to the circumstance when the two sharp edges are distinct.

As shown in Figure 7, there may be a triple point, at the end face 613 of the conductive body 61, for example at the sharp edge 68. A triple point is a junction between a conductive surface, an insulating surface and the ambient environment or atmosphere (which may be at a low pressure, for example a vacuum). The triple point at the sharp edge 68 is a junction between the conductive element of the conductive body 61, the electrical insulator 70 and the atmosphere. In general, undesirable electron creep may initiate at or near such a triple point. As shown from a comparison between Figure 8 and Figure 7, in an embodiment the sharp edge is covered by the electrical insulator 70. Covering the sharp edge 68 may prevent the sharp edge from functioning as a triple point. The sharp edge 68 shown in Figure 7 may be considered to have been trapped or encapsulated by the electrical insulator 70. As a result of the encapsulation, there is a triple point is located within the field free volume 62. As shown in Figure 8, there is an interface 69 on the recessed surface of the conductive body 61 with an insulating surface and the atmosphere. Effectively the location of the triple point is moved from sharp edge 68 at the end face 613 of the conductive body 61 into the field free volume 62. By arranging the conductive body 61 such that the triple point is within the field free volume 62, for example at interface 69, the possibility of electron creep is reduced. In particular, the surface over which electron creep is required to occur is increased by relocating the triple point from the surface of the sharp edge 68 at the end face 613 of the conductive body to the interface 69 within the field free volume 62. Moving the position of the triple point into the field free region increases the size of the surface over which electron creep occurs in the event of electrical discharge. Thus electrical discharge caused by electron creep may be prevented, or at least the risk reduced, by moving the triple point, i.e. as a starting point of such electron creep, into the field free volume.

In an embodiment the sharp edge (or sharp end) 68 of the conductive body 61 is encapsulated to reduce if not prevent electron release and to move the triple point into the field free volume 62. As shown in Figure 8, in an embodiment the electrical insulator comprises an insulating member 72 as the end face 613 of the conductive body 61. The insulating member covers the sharp edge 68. In an embodiment the electrical insulator 70 at the end face comprises an insulating member 72 that covers the end face 613 (or face) of the conductive body 61. In an embodiment the insulating member 72 is formed integrally. In an embodiment the insulating member 72 is initially formed as a separate component from the rest of the electrical insulator 70. For example, in an embodiment the electrical insulator 70 comprises the insulating member 72 and an insulating cover 71. The insulating cover 71 is configured to cover at least part of the exterior surface 612 of the conductive body 61. In an embodiment the electrical insulator 70 has at least two pieces.

In an embodiment the insulating member 72 comprises an insulating plug that comprises (or at least covers) the end face of the conductive body 61. In an embodiment the insulating plug extends through the opening to the field free volume 62 to provide at least part of the surface of the recess 611 (or the recessed surface). In an embodiment the insulating plug extends into the field free volume 62. The portion of the plug that extends into the recess 611 may be referred to as an inward portion. In an embodiment the insulating member 72 is an insulating plug engaged with the end face 613 of the conductive body 61. The portion of the plug that covers the end face of the conductive body 61 may be referred to as a cover portion. In an embodiment the insulating member 72 is configured to engage with the inner surface of the conductive body 61 for example within the recess 611.

The electrical insulator 70 comprises an electrically insulating material. For example, in an embodiment the electrical insulator comprises a dielectric such as a ceramic, glass (e.g. a borosilicate glass), and epoxy or an insulating adhesive. In an embodiment the insulating cover 71 and the insulating member 72 are formed of the same dielectric material. Alternatively, the insulating cover 71 may comprise a different material from the material of the insulting member 72.

In an embodiment the conductive body 61 is formed by milling, machining, cutting or laser ablating, or other such means of forming, a mass of conductive material. In an embodiment the conductive body 61 comprises rounded edges. In an embodiment the conductor 67 has one or more rounded edges. Rounded edges can help to reduce electric fields around the conductive body 61 and/the conductor. This is because the rounding of the surface so the conductive body 61 may help to limit the local field enhancement in the insulator that covers the conductive body 61. Limiting the local field enhancement ensures that the field does not exceed the dielectric strength of the insulator. If the field does locally exceed, for example at the edge of the conductive body 61, electric breakdown of the insulator could occur. In an embodiment the conductive body 61 is formed as a layer such as a coating. For example, a conductive material may be applied in a layer, for example coated, onto the down beam isolator 760 and/or a surface of the electrical insulator 70 in order to form the conductive body 61 or at least the conductive element of the conductive body 61. For example the conductive layer 78 may be formed of one continuous layer. In another embodiment, the conductive layer 78 may be formed of at least part of a layer on the isolator 760 and a layer on a surface of the electrical insulator for example of the insulating cover 71, for example the layer on the isolator may be joined to the layer on the electrical insulator.

It is not essential for the electrical insulator 70 to comprise the insulating member 72. Similarly it is not essential for the electrical insulator 70 to comprise the insulating cover 71. In an embodiment the electrical insulator 70 consists of the insulating member 72. Part of the exterior surface 612 of the conductive body 61 may be covered by the down beam isolator 760 and the insulating member 72, with other parts of the exterior surface 612 of the conductive body 61 open to the environment.

As shown in Figure 8, in an embodiment the electrical insulator 70 extends into the field free volume 62 from the end face 613. In an embodiment the electrical insulator 70 provides a part of an internal surface (or the recessed surface of the recess 611) of the conductive body 61. In an embodiment the electrical insulator 70 provides a part of the internal surface of the conductive body remote from the electron-optical element. In an embodiment the internal surface of the conductive body 61 defines the field free volume 62. In an embodiment the electrical insulator 70 extends into the field free volume 62, covering part of an internal surface of the conductive body 61, the internal surface defining the field free volume 62. Expressed differently, the recessed surface may comprises a surface of the inward portion of the plug and the a portion of the conductive body 61. The portion of the conductive body 61 may be referred to as an exposed portion of the conductive body. The exposed portion is the part of the surface of the conductive body in the recess 611 that remains exposed, for example uncovered by the plug (or the insulating member 72).

In an embodiment at least a part of the electrical insulator 70 surrounds a cross section of the conductive body 61. In the arrangements shown in Figure 7 and Figure 8, a cross-section of the conductive body 61 perpendicular to the axial direction of the field free volume 62 is surrounded by a combination of the insulating cover 71 and the down beam isolator 760. In an alternative embodiment, the insulating cover 71 surrounds a cross-section of the conductive body 61. An embodiment of the invention is expected to reduce the possibility of electron creep over the surface of the conductive body 61 for example in any direction for example from a triple point formed at the edge of a exposed (or uncovered) conductive surface of the conductive body.

As shown in Figure 7, in an embodiment the longitudinal axis of the field free volume 62 is offset from the plate 710 of the electron-optical element. In an embodiment the field free volume 62 defines an axial direction distanced from the plane of the planar electron-optical element. The distance between the end of the conductive body 61 and the electron-optical elements of the stack may be increased so as to reduce the risk of discharge between the conductive body 61 and the stack. There may be a gap between the end of the conductive body 61 and the electron-optical elements of the stack.

In an embodiment the field free volume 62 defines an axial direction which is angled relative to the plane of the planar electron-optical element. For example, in an embodiment the axial direction of the field free volume 62 is angled out of the plane of the planar electron-optical element. The field free volume 62 may be directed upwards or downwards relative to the plate 710 in the orientation shown in Figure 7, for example. By changing the angle of the conductive body 61, the end of the conductive body 61 may be distanced further from the stacks so as to reduce the risk of discharge. This configuration may also facilitate electrically connecting the conductive body and thus the electron-optical element for example if the available design volume is limited. However, it is not essential for the field free volume 62 to be angled relative to the plate 710. In an alternative embodiment the axial direction defined by the field free volume 62 is parallel to the plane of the plate 710, for example as shown in Figure 7.

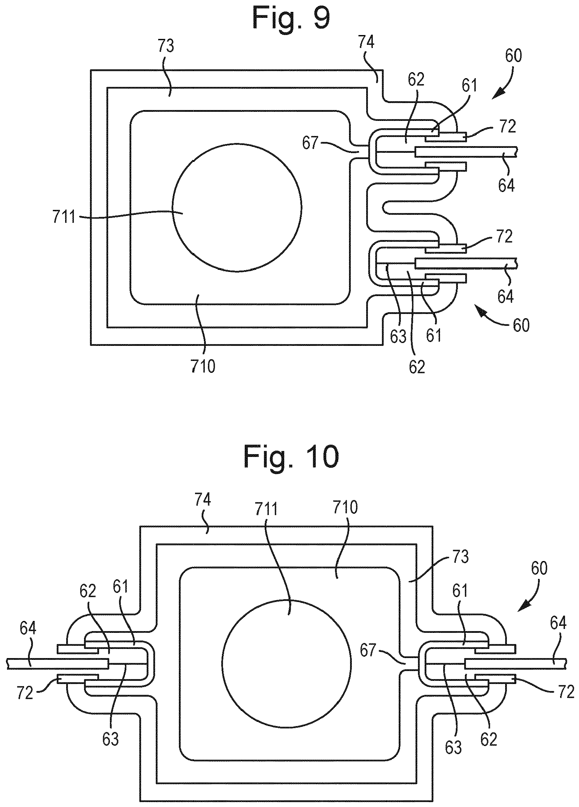

Figure 9 is a schematic plan view of an electron-optical assembly comprising two electrical connectors 60. In an embodiment the electrical connectors 60 are for electrically connecting respective electron-optical elements of the electron-optical assembly to respective electrical power sources. As shown in Figure 9, in an embodiment the electron-optical assembly comprises a plurality of conductive bodies 61. The conductive bodies 61 are electrically connected to one or more electron-optical elements of the electron-optical assembly. For example, the electrical connector 60 shown in the top half of Figure 9 is for electrically connecting the plate 710 to an electrical power source. The conductive body 61 is electrically connected to the plate 710 of the electron-optical element. The plate may have one more apertures defined therein for the path of one or more charged particle beams. The electrical connector 60 shown in the bottom half of Figure 9 may be for electrically connecting another plate in the stack of the electron-optical assembly to the same or another electrical power source.

In an embodiment the electron-optical device comprising the electron-optical assembly comprises a plurality of electrical power sources. In an embodiment a controller 50 is provided to control the voltages applied to the electron-optical elements by the electrical power sources. In an embodiment the controller 50 is configured to control different high voltages to be applied to different electron-optical elements of the electron-optical assembly. Additionally or alternatively, a plurality of electrical power sources may be connected to different parts of the same electron-optical element. The controller 50 may control the electrical power sources such that different high voltages are applied to different parts of the electron-optical element. The controller 50 is configured to control the voltages applied to the electron-optical elements so as to control the manipulation of the one or more electron beams by the electron-optical assembly.

Many features shown in Figure 9 are described above in relation to other Figures. These features are labelled with the same reference numerals as used earlier in this document. These features are not described further in detail so as to avoid redundant description. The description below focusses on features that are not shown in other Figures.

As shown in Figure 9, in an embodiment the electrical insulator 70 covers at least part of a surface of a plurality of the conductive bodies 61. For example, as shown in Figure 9 in an embodiment the electrical insulator 70 comprises potting 73. The potting comprises an insulating material. The potting 73 is configured to cover the outer surface of one or more of the conductive bodies 61. The potting 73 is configured to reduce the possibility of the release of electrons from the conductive bodies 61. The potting 73 is provided to reduce or eliminate voids/pockets of gas or vacuum which may otherwise undesirably enhance the electric field. In an embodiment the potting 73 is formed of a fluid that solidifies to form a dielectric layer. In an embodiment the potting 73 comprises an epoxy or an insulating adhesive, for example. In an embodiment the electrical insulator 70 comprises at least part of a surface common to a plurality of the conductive bodies 61. In an embodiment the electrical insulator 70 is common to a plurality of the conductive bodies 61.

As shown in Figure 9, in an embodiment in plan view a plurality of the conductive bodies 61 are positioned on the same side of the beam path. The beam path extends through a central region of the plate 710. For ease of depiction the stack is shown to have a square outer shape in cross-section, but it could have any desirable shape as disclosed herein. As shown in Figure 9, in an embodiment a plurality of the conductive bodies 61 define field free volumes 62 that have axial directions that are parallel to each other. The electrical connectors 60 may extend out from the same side of the stack of the electron-optical assembly. This may reduce the space taken up by electrical connections on other sides of the stack, for example to meet volume constraints in the electron-optical device.

Figure 10 is a schematic plan view of an electron-optical assembly. Unless otherwise stated it takes on the same features having the same description as Figure 9. The electron-optical assembly shown in Figure 10 has two conductive bodies 61 on opposite sides of the stack of the electron-optical assembly. As shown in Figure 10, in an embodiment two of the conductive bodies 61 are arranged to have the beam path between them; the cross-sectional shape of the stack, across the beam path, as depicted may be square. By positioning the conductive bodies 61 on different sides of the stack of the electron-optical assembly, the conductive bodies 61 may be placed further apart from each other. By placing the conductive bodies 61 further apart from each other, the length of the creep path between the conductive bodies 61 may be extended. However, it is not essential for two of the conductive bodies 61 to be arranged to have the beam path between them. For example, as shown in Figure 9 in an embodiment all of the electrical connectors 60 are placed on the same side of the electron-optical assembly. In a different embodiment, the electrical connectors are placed on adjacent sides for example to address volume constraints and to increase the creep length between the two conductive bodies (or between the triple points of the two conductive bodies) compared to the arrangement shown in and described with reference to Figure 9.

As shown in Figure 9 and Figure 10, in an embodiment the electrical insulator 70 comprises a casing 74. In an embodiment the casing 74 comprises a dielectric such as a ceramic and/or a glass (e.g. a borosilicate glass). In an embodiment the potting 73 is provided to fill the gaps between the casing 74 and the conductive bodies 61. The potting 73 may be provided after the conductive body 61 has been positioned relative to the casing 74 of the electrical insulator 70. As shown in Figure 9 or Figure 10, in an embodiment the casing 74 substantially surrounds the stack of the electron-optical assembly when viewed in plan view. In an embodiment potting fills in between the casing and the stack. The potting may fill the gap between the stack and the individual conductive bodies 61.

Figure 9 shows two conductive bodies 61 on the same side of the electron-optical assembly. The conductive bodies 61 are adjacent to each other. As shown in Figure 9, in an embodiment the casing 74 defines an intermediate recess between the conductive bodies 61. In an alternative embodiment, the recess is filled in with the material that forms the casing 74. The casing 74 may be thicker in this region. In another embodiment, the casing 74 bridges the intermediate recess for example in a straight line between the two conductive bodies 61. The intermediate recess is filled with potting 73. In this case, the potting material would be thicker, for example as compared to the previous example in which the casing 74 is thicker.

In the arrangement shown in Figure 10, for example, the conductive body 61 on the right hand side of Figure 10 is electrically connected to the plate 710 by the conductor 67. The conductive body 61 on the left hand side of Figure 10 is electrically isolated from the plate 710 by the potting 73 of the electrical insulator 70. The conductive body 61 on the left hand side of Figure 10 is electrically connected to another electron-optical element of the electron-optical assembly that comprises the plate 710. As shown in Figure 10 (and similarly in Figure 9), in an embodiment the electrical insulator 70 extends between the conductive body 61 and one or more further electron-optical elements configured to operate on the electron beam. The electrical insulator 70 is configured to reduce the possibility of electrical breakdown between the conductive body 61 and other electron-optical elements of the electron-optical assembly. In an embodiment the electrical insulator 70 extends towards one or more further electron-optical elements configured to operate on the electron beam. In an embodiment the electrical insulator 70 extends to one or more further electron-optical elements. Additionally or alternatively, an insulating element is between the conductive body 61 and the one or more further electron-optical elements. The insulating element 70 may be between the conductive body 61 and one or more electron-optical elements of the stack.

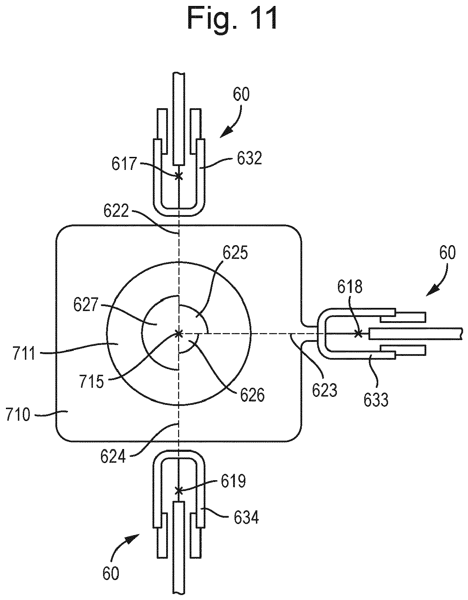

As shown in Figure 10, in an embodiment the conductive bodies 61 may define field free volumes 62 that have axial directions that are parallel to each other (albeit being in opposite directions). However, this is not necessarily the case. In an alternative embodiment, a plurality of the conductive bodies 61 are arranged such that their field free volumes define different axial directions, for example angled or perpendicular axial directions. Figure 11 is a schematic plan view of an electron-optical assembly. The electrical insulator 70 is not shown in Figure 11. The form of the electrical insulator 70 may be similar to as shown in Figure 9 or Figure 10, for example. As shown in Figure 11, a plurality of the conductive bodies 632-634 are arranged such that their field free volume 62 define different axial directions. The axial direction for the electrical connector 60 on the right hand side of the Figure 11 (which is electrically connected to the plate 710) may be perpendicular to the axial direction for the other electrical connectors shown in the top and bottom parts of Figure 11. The electrical connectors 60 may be distanced from each other. Additionally or alternatively, a plurality of the conductive bodies 632-634 may be positioned to adjoin each other. For example, a plurality of the conductive bodies 632-634 may be positioned to adjoin each other, with substantially common axial directions or proximate axial directions.

As illustrated in Figure 11, each of the conductive bodies 61 may be associated with an imaginary line 622-624 between a centre 617-619 of the conductive body and a centre 715 of the aperture (or plurality of apertures 711) of the plate 710 of the electron-optical element. In Figure 11, a first imaginary line 622 is between the centre 617 of the conductive body 632 shown at the top of Figure 11 and the centre 715 of the aperture (or plurality of apertures 711). A second imaginary line 623 is between the centre 618 of the conductive body 633 at the right hand side of Figure 11 and the centre 715 of the aperture. A third imaginary line 624 is between the centre 619 of the conductive body 634 shown in the bottom of Figure 11 and the centre 715 of the aperture. The centre 715 of the aperture may be the centre of the plate 710. The centre of the plate 710 may correspond to the path of the beam grid for example a mid-point of the beam grid. The different conductive bodies 61 may each have a center 617-619 that corresponds to the centre of the field free volume defined by the conductive body 61.

In an embodiment the conductive bodies 632-634 are arranged such that a minimum angle between any pair of the imaginary lines 622-624 is at least 360°/2N. N is the number of conductive bodies 632-634. For example, in the arrangement shown in Figure 11 there are three conductive bodies 632-634. The conductive bodies 632-634 are arranged such that a minimum angle between any pair of the imaginary lines 622-624 is at least 360°/(2x3) = 360°/6 = 60°. As shown in Figure 11, the angle 625 between the first imaginary line 622 and the second imaginary line 623 is 90°, which is greater than 60°. The angle 626 between the second imaginary line 623 and the third imaginary line 624 is 90°, which is greater than 60°. The angle 627 between the third imaginary line 624 and the first imaginary line 622 is 180°, which is greater than 60°. In an embodiment the conductive bodies are arranged such that the angles between adjacent pairs of imaginary lines are equal. The conductive bodies 61 may be evenly distributed circumferentially around the centre 715 of the aperture of the plate 710 of the electron-optical element. For example, for three conductive bodies, the angles between the imaginary lines may be 120°. The conductive bodies 632-634 may be equidistant from each other or, as depicted, two of the conductive bodies 632, 634 may be equidistant from the third of the three conductive bodies 633.

As shown in Figure 11, in an embodiment the axial directions of the conductive bodies 632-634 are with respect to an exterior surface of the electron-optical assembly. In an embodiment the exterior surface is of a side of the electron-optical assembly in a direction across the beam path. In an embodiment the exterior surface is orthogonal to the beam path. In an embodiment the side of the electron-optical assembly is of a rectilinear shape. In an embodiment the side of the electron-optical assembly is a rectangle, for example a square. In the arrangement shown in Figure 11, for example, the stack has a roughly square shape with rounded corners. In an embodiment the electrical connectors 60 are positioned at different sides of the stack.

It is not essential for the stack to have a rectangular shape. For example, in an embodiment the stack may be circular, elliptical triangular, pentagonal, hexagonal, heptagonal, octagonal, or any other rectilinear shape (e.g. rhombic) for example. Note a circular stack would be beneficial for thermal management reasons for even thermal distribution across the cross-section of the stack. For example, when five electrical connectors 60 are provided, then the stack may have a pentagonal shape such that each electrical connector 60 is provided at a different side of the electron-optical assembly. Additionally or alternatively, one or more sides of the electron-optical assembly, when reading plan view, may have a plurality of electrical connectors associated with it. An electrical connector may be provided at a rounded corner of a stack. The shape of the stack may be regular or irregular for example with sides of similar length or dissimilar lengths, or a shape with two or more sides the same length. The cross-sectional shape of the electron-optical assembly may be similar to that of the stack, so may take any shape disclosed herein of the stack. However, the cross-sectional shapes of the stack and the electron-optical assembly need not be similar because the cross-sectional shape of the electron-optical assembly comprises insulating material 70 and/or casing which can have a dissimilar cross-sectional shape to the stack for example because the conductive bodies are incorporated into the shape of the cross-section of electron-optical assembly which are not present in the stack. Even if the cross-sectional shapes of the stack and the electron-optical are dissimilar, the same range of different cross-sectional shapes available to the stack may be available to the electron-optical assembly

As mentioned above, in an embodiment the surface covered by the electrical insulator 70 may face away from the electron-optical element. For example, as shown in Figure 7 in an embodiment the surface 612 covered by the electrical insulator 70 faces away from the electron-optical element in a direction parallel to the beam path. In the orientation of Figure 7, the beam path extends in the updown direction (or in a direction from upbeam to down beam). The top part of the electrical insulator 70 is directly above the conductive body 61, for example in contact with the conductive body 61, such that the electrical insulator 70 covers a most upward facing surface of the conductive body 61.

Additionally or alternatively, in an embodiment the surface covered by the electrical insulator 70 faces away from the electron-optical element in a direction across the beam path, desirably perpendicular to the beam path. For example, as shown in Figure 7 or Figure 8, in an embodiment the end face 613 of the conductive body 61, which faces away from the electron-optical element, is covered by the insulating member 72 of the electrical insulator 70. Additionally or alternatively, in an embodiment the electrical insulator 70 covers an inward facing surface 614 of the conductive body 621, namely a surface that faces towards the electron-optical element.

In addition two or more electrical connectors of an electrical-optical assembly may be positioned at different positions relative to the stack, in a direction along parallel to the beam path and/or two or more of the electrical connectors may be positioned at substantially the same position in a direction parallel to the beam path.

Although different embodiments and different arrangements for example in the different relative positioning of an individual electrical connector 60 (and conductive body 61) relative to the stack and positioning of different electrical connectors 60 (and the associated conductive bodies 61) with respect to the stack and each other respectively have disclosed herein, the different variations may be combined in any reasonable way.

In an embodiment the electron-optical assembly 700 comprises one or more electron-optical elements which comprise an element which may be referred to as a microelectromechanical component (despite such component may not comprise a moving or moveable feature) or may be made using techniques suited to make microelectromechanical components (for example a 'MEMS technique') some of which are designed to have electron-optical functionality. The electron-optical assembly 700, or at least components of the electron-optical assembly 700, may be manufactured by such techniques. The electron-optical assembly 700 may comprise one or more elements which may be considered MEMS elements. One or more of such elements may be controlled to be set at a high potential difference relative to a reference potential (e.g. ground) during use. Such elements may require accurate positioning (for example alignment) within the electron-optical assembly 700 for example with respect to the path of the beam grid and with respect to other electron-optical elements within the device for example with respect to a source, with respect to a sample and/or the path of the beam grid. An embodiment of the invention is expected to allow for more accurate positioning (for example alignment) of such elements within the stack of such an electron-optical assembly 700 such as during operation for example without distortion of the electron-optical assembly 700 for example by externally applied force or moment. An embodiment of the invention may in addition or alternatively enable more accurate positioning, for example alignment, of such elements with respect to other elements in the device 40 and thus of the stack of the electron-optical assembly 700 comprising such elements within the device 40.

As mentioned above, in an embodiment the electron-optical assembly 700 is an electron-optical lens assembly. The electron-optical lens assembly may comprise an objective lens assembly. The electron-optical lens assembly may be an objective lens assembly. In an alternative embodiment the electron-optical lens assembly is an electron-optical condenser lens assembly.

In an embodiment the electron-optical assembly 700 comprises a collimator. For example, in an embodiment the electron-optical assembly 700 comprises a magnetic collimator in combination with an electro static condenser lens arrays. The electron-optical assembly 700 may comprise a single aperture lens array with one or two macro electrodes, placed away from the virtual source conjugate plane.

In an alternative embodiment, the electron-optical assembly 700 comprises a magnetic macro lens in combination with an electrostatic slit deflector. The magnetic macro lens may be for collimating. As a further alternative, in an embodiment the electron-optical assembly 700 comprises a combined magnetic and electrostatic macro lens and a downbeam slit deflector.

In general, the electron-optical assembly 700 may comprise any plates such as a plate of a detector array, a plate of a lens electrode (into which multiple deflectors may be integrated) multiple deflector arrays, beam aperture arrays (e.g. an upper beam aperture array and/or a final beam limiting array), deflector arrays (e.g. strip deflector arrays) and other types of corrector elements.

The embodiments described within this document have focused primarily on multi-beam electron-optical devices 40. The invention is equally applicable to single-beam electron-optical devices 40.

While the present invention has been described in connection with various embodiments, other embodiments of the invention will be apparent to those skilled in the art from consideration of the specification and practice of the invention disclosed herein. For example, as described above in an embodiment the electron-optical assembly 700 comprises the electrical connector 60. However, an electrical connector 60 of the invention can be used anywhere in the electron-optical device 40 where a problem of possible electrical breakdown may exist. In an embodiment the electron-optical device 40 comprises the electrical connector 60 separately from the electron-optical assembly 700. For example the electrical connector 60 may be located where a low force electrical connection with other parts of the electron-optical device 40 such as the body or frame of the electron-optical device 40 is desirable. The electrical connector 60 may be located where the electrical connection is not required to be particularly low force. The electrical connector 60 may make the electron-optical device 40 more compact while providing a field free volume. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.
Clause 1. A charged particle-optical assembly configured to direct a beam of charged particles along a beam path towards a sample location, the charged particle-optical assembly comprising: a planar charged particle-optical element configured to operate on a charged particle beam along a beam path towards a sample location, the charged particle-optical element comprising an aperture for the beam path; and a conductive body electrically connected to the charged particle-optical element, wherein a recess is defined within the conductive body and is configured to provide a field free volume for insertion of a high voltage cable for electrically connecting the charged particle-optical element via an electrical coupling with an electrical power source; wherein the conductive body comprises an electrical insulator spaced away from the planar charged particle-optical element and providing at least part of a surface of the conductive body.
Clause 2. The charged particle-optical assembly of clause 1, wherein an end face of the conductive body comprises the at least part of the surface of the conductive body, wherein in the end face is defined an opening to the field free volume.
Clause 3. The charged particle-optical assembly of clause 2, wherein the electrical insulator comprises an insulating member as the end face.
Clause 4. The charged particle-optical assembly of clause 3, wherein the insulating member comprises an insulating plug that comprises the end face of the conductive body and optionally extends through the opening to provide at least part of the surface of the recess, desirably extending into the field free volume.
Clause 5. The charged particle-optical assembly of any of clauses 2 to 4, wherein electrical insulator extends into the field free volume from the end face desirably so as to provide a part of an internal surface of the conductive body desirably a remote part of the internal surface from the charged particle-optical element, desirably the internal surface defining the field free volume.
Clause 6. The charged particle-optical assembly of any preceding clause, wherein at least a part of the electrical insulator surrounds a cross section of the conductive body.
Clause 7. The charged particle-optical assembly of any preceding clause, comprising a plurality of conductive bodies electrically connected to one or more charged particle-optical elements of the charged particle-optical assembly.
Clause 8. The charged particle-optical assembly of clause 7, wherein the electrical insulator comprises at least part of a surface common to a plurality of the conductive bodies and/or the electrical insulator is common to a plurality of the conductive bodies.
Clause 9. The charged particle-optical assembly of clause 8, wherein the electrical insulator further comprises a continuous volume between the plurality of conductive bodies, desirably providing the surface common to the plurality of the conductive bodies.
Clause 10. The charged particle-optical assembly of any of clauses 7-9, wherein two of the conductive bodies are arranged to have the beam path between them.
Clause 11. The charged particle-optical assembly of any of clauses 7-10, wherein a plurality of the conductive bodies are arranged such that their field free volumes define different axial directions.
Clause 12. The charged particle-optical assembly of any of clauses 7-11, wherein a plurality of the conductive bodies are positioned to adjoin each other desirably with substantially common axial directions or proximate axial directions.
Clause 13. The charged particle-optical assembly of any of clauses 7-12, wherein each of the conductive bodies is associated with an imaginary line between a centre of the conductive body and a centre of the plurality of apertures, and the conductive bodies are arranged such that a minimum angle between any pair of the imaginary lines is at least 360°/2N, where N is the number of conductive bodies, desirably the axial directions are with respect to an exterior surface of the charged particle-optical assembly, desirably the exterior surface is of a side of the charged particle-optical assembly in a direction across the beam path, desirably orthogonal to the beam path, desirably the side is of a rectilinear shape, for example a rectangle e.g. a square.
Clause 14. The charged particle-optical assembly of any preceding clause, wherein the conductive body comprises a conductive element, the surface of the recess comprising a surface of the conductive element, wherein the electrical insulator of the conductive body is thicker than a conductive element, desirably the conductive element is within the electrical insulator, the conductive element may comprise a conductive layer for example on the electrical insulator.
Clause 15. The charged particle-optical assembly of any preceding clause, wherein the electrical insulator of the conductive body extends towards, desirably to, one or more further charged particle-optical elements configured to operate on the charged particle beam and/or an insulating element is between the conductive body and the one more further charged particle-optical elements.
Clause 16. The charged particle-optical assembly of any preceding clause, wherein the surface of the electrical insulator faces away from the charged particle-optical element in a direction parallel to the paths of the charged particle beams
Clause 17. The charged particle-optical assembly of any preceding clause, wherein the surface of the electrical insulator faces away from the charged particle-optical element in a direction across the paths of the charged particle beams.
Clause 18. The charged particle-optical assembly of any preceding clause, wherein the beam of charged particles comprises a plurality of beams along the beam path and, desirably, the charged particle-optical element comprises a plurality of apertures, individual apertures for a respective beam of the plurality of beams.
Clause 19. A charged particle-optical assembly configured to direct a plurality of beams of charged particles along a beam path towards a sample location, the charged particle-optical assembly comprising: a planar charged particle-optical element configured to operate on a charged particle beam along a beam path towards a sample location, the charged particle-optical element comprising an aperture for the beam path; and a conductive body electrically connected to the charged particle-optical element, wherein a recess is defined within the conductive body and is configured to provide a field free volume for insertion of a high voltage cable for electrically connecting the charged particle-optical element via an electrical coupling with an electrical power source; wherein an electrical insulator covers at least part of a surface of the conductive body, the surface facing away from the charged particle-optical element.
Clause 20. The charged particle-optical assembly of clause 19, wherein the electrical insulator covers an end face of the conductive body, wherein in the end face is defined an opening to the field free volume.
Clause 21. The charged particle-optical assembly of clause 20, wherein the electrical insulator at the end face comprises an insulating member that covers the end face of the conductive body.
Clause 22. The charged particle-optical assembly of clause 21, wherein the insulating member is an insulating plug engaged with the end face of the conductive body.
Clause 23. The charged particle-optical assembly of any of clauses 20-22, wherein desirably in addition to covering the end face, the electrical insulator extends into the field free volume, covering part of an internal surface of the conductive body, the internal surface defining the field free volume.
Clause 24. The charged particle-optical assembly of any of clauses 19-23, wherein at least a part of the electrical insulator surrounds a cross section of the conductive body.
Clause 25. The charged particle-optical assembly of any of clauses 19-24, comprising a plurality of conductive bodies electrically connected to one or more charged-particle optical elements of the charged particle-optical assembly
Clause 26. The charged particle-optical assembly of clause 25, wherein the electrical insulator covers at least part of a surface of a plurality of the conductive bodies.
Clause 27. The charged particle-optical assembly of clause 26, wherein the electrical insulator comprises a continuous volume between the surfaces of the conductive bodies covered by the electrical insulator.
Clause 28. The charged particle-optical assembly of any of clauses 25-27, wherein two of the conductive bodies are arranged to have the beam path between them.
Clause 29. The charged particle-optical assembly of any of clauses 25-28, wherein a plurality of the conductive bodies are arranged such that their field free volumes define different axial directions.
Clause 30. The charged particle-optical assembly of any of clauses 25-29, wherein a plurality of the conductive bodies are positioned to adjoin each other desirably with substantially common axial directions or proximate axial directions.
Clause 31. The charged particle-optical assembly of any of clauses 25-30, wherein each of the conductive bodies is associated with an imaginary line between a centre of the conductive body and a centre of the aperture, and the conductive bodies are arranged such that a minimum angle between any pair of the imaginary lines is at least 360°/2N, where N is the number of conductive bodies.
Clause 32. The charged particle-optical assembly of any of clauses 19-31, wherein the electrical insulator is thicker, for example in a direction away from the axial direction of the field free volume, than the conductive body where the electrical insulator covers the surface of the conductive body.
Clause 33. The charged particle-optical assembly of any of clauses 19-32, wherein the electrical insulator extends between the conductive body and one or more further charged particle-optical elements configured to operate on the charged particle beam.
Clause 34. The charged particle-optical assembly of any of clauses 19-33, wherein the surface covered by the electrical insulator faces away from the charged particle-optical element in a direction parallel to the beam path.
Clause 35. The charged particle-optical assembly of any of clauses 19-34, wherein the surface covered by the electrical insulator faces away from the charged particle-optical element in a direction across the beam path, desirably the paths of the charged particle beams.
Clause 36. The charged particle-optical assembly of any preceding clause, wherein the field free volume defines an axial direction distanced from the plane of the planar charged particle-optical element.
Clause 37. The charged particle-optical assembly of any preceding clause, wherein the field free volume defines an axial direction angled relative to the plane of the planar charged particle-optical element, for example angled out of the plane of the planar charged particle-optical element.
Clause 38. The charged particle-optical assembly of any preceding clause, comprising an isolator configured to: support and electrically isolate the charged particle-optical element, and be positioned away from the beam path.
Clause 39. A charged particle-optical device for projecting a plurality of charged particle beams along respective beam paths towards a sample location, the charged particle-optical device comprising: one or more charged particle-optical assemblies of any preceding clause.
Clause 40. A charged particle-optical apparatus comprising: the charged particle-optical assembly of any of clauses 1-38 or the charged particle-optical device of clause 39; and an actuatable stage configured to support a sample.
Clause 41. A method of electrically insulating a conductive body of a charged particle-optical assembly configured to direct a beam of charged particles towards a sample location, the method comprising: covering at least part of a surface of the conductive body with one or more electrical insulators, the surface facing away from a planar charged particle-optical element to which the conductive body is electrically connected, the charged particle-optical element configured to operate on a charged particle beam along a beam path and comprising an aperture for the beam path, wherein a recess is defined within the conductive body and is configured to provide a field free volume for insertion of a high voltage cable for electrically connecting the charged particle-optical element via an electrical coupling with an electrical power source.
Clause 42. A method of electrically insulating a conductive body of a charged particle-optical assembly configured to direct a beam of charged particles along a beam path towards a sample location, the charged particle-optical assembly comprising a planar charged particle-optical element for operating on the charged particle beam, the method comprising: having a conductive body having a conductive recessed surface of a recess of the conductive body, the conductive body comprising an electrical insulator spaced away from the planar charged particle-optical element, the planar charged particle-optical element electrically connected to the conductive body, wherein the recess is configured within the conductive body to provide a field free volume for insertion of a high voltage cable for electrical connection of the charged particle-optical element via an electrical coupling between the conductive body and the high voltage cable to an electrical power source.
Clause 43. A charged particle-optical assembly configured to direct a plurality of beams of charged particles along a beam path towards a sample location, the charged particle-optical assembly comprising: a planar charged particle-optical element configured to operate at a voltage on a charged particle beam along a beam path towards a sample, the charged particle-optical element comprising an aperture for the beam path; and a conductive body electrically connected to the charged particle-optical element, wherein a recess is defined within the conductive body and is configured to provide a field free volume for insertion of a high voltage cable for electrical connection of the charged particle-optical element via an electrical coupling with an electrical power source; wherein the conductive body comprises an electrical insulator that comprises at least an end face of the conductive body and an extending surface extending from the end face into the recess.

## Claims

1. A charged particle-optical assembly configured to direct a beam of charged particles along a beam path towards a sample location, the charged particle-optical assembly comprising:
a planar charged particle-optical element configured to operate on a charged particle beam along a beam path towards a sample location, the charged particle-optical element comprising an aperture for the beam path; and
a conductive body electrically connected to the charged particle-optical element, wherein a recess is defined within the conductive body and is configured to provide a field free volume for insertion of a high voltage cable for electrically connecting the charged particle-optical element via an electrical coupling with an electrical power source;
wherein the conductive body comprises an electrical insulator spaced away from the planar charged particle-optical element and providing at least part of a surface of the conductive body.

2. The charged particle-optical assembly of claim 1, wherein an end face of the conductive body comprises the at least part of the surface of the conductive body, wherein in the end face is defined an opening to the field free volume.

3. The charged particle-optical assembly of claim 2, wherein the electrical insulator comprises an insulating member as the end face.

4. The charged particle-optical assembly of claim 3, wherein the insulating member comprises an insulating plug that comprises the end face of the conductive body and optionally extends through the opening to provide at least part of the surface of the recess, desirably extending into the field free volume.

5. The charged particle-optical assembly of any of claims 2 to 4, wherein electrical insulator extends into the field free volume from the end face desirably so as to provide a part of an internal surface of the conductive body desirably a remote part of the internal surface from the charged particle-optical element, desirably the internal surface defining the field free volume.

6. The charged particle-optical assembly of any preceding claim, wherein at least a part of the electrical insulator surrounds a cross section of the conductive body.

7. The charged particle-optical assembly of any preceding claim, comprising a plurality of conductive bodies electrically connected to one or more charged particle-optical elements of the charged particle-optical assembly.

8. The charged particle-optical assembly of claim 7, wherein the electrical insulator comprises at least part of a surface common to a plurality of the conductive bodies and/or the electrical insulator is common to a plurality of the conductive bodies.

9. The charged particle-optical assembly of claim 8, wherein the electrical insulator further comprises a continuous volume between the plurality of conductive bodies, desirably providing the surface common to the plurality of the conductive bodies.

10. The charged particle-optical assembly of any of claims 7-9, wherein at least one of
a. two of the conductive bodies are arranged to have the beam path between them;
b. a plurality of the conductive bodies are arranged such that their field free volumes define different axial directions; and
c. a plurality of the conductive bodies are positioned to adjoin each other desirably with substantially common axial directions or proximate axial directions.

11. The charged particle-optical assembly of any preceding claim, wherein the conductive body comprises a conductive element, the surface of the recess comprising a surface of the conductive element, wherein the electrical insulator of the conductive body is thicker than a conductive element, desirably the conductive element is within the electrical insulator, the conductive element may comprise a conductive layer for example on the electrical insulator.

12. The charged particle-optical assembly of any preceding claim, wherein the electrical insulator of the conductive body extends towards, desirably to, one or more further charged particle-optical elements configured to operate on the charged particle beam and/or an insulating element is between the conductive body and the one more further charged particle-optical elements.

13. The charged particle-optical assembly of any preceding claim, wherein the surface of the electrical insulator faces away from the charged particle-optical element in a direction parallel to the paths of the charged particle beams

14. The charged particle-optical assembly of any preceding claim, wherein the surface of the electrical insulator faces away from the charged particle-optical element in a direction across the paths of the charged particle beams.

15. The charged particle-optical assembly of any preceding claim, wherein the beam of charged particles comprises a plurality of beams along the beam path and, desirably, the charged particle-optical element comprises a plurality of apertures, individual apertures for a respective beam of the plurality of beams.
